# EUROPÄISCHE PATENTSCHRIFT

(11) **EP 1 772 902 B1**
(45) Veröffentlichungstag und Bekanntmachung des Hinweises auf die Patenterteilung: **17.09.2008**
(21) Anmeldenummer: 06020798.2
(22) Anmeldetag: 04.10.2006
(51) Int. Cl.: H01L 23/373

(54) **Leistungshalbleitermodul mit Isolationszwischenlage und Verfahren zu seiner Herstellung**
Power semiconductor modul with intermediate isolating layer und method of manufacturing
Module semiconducteur de puissance avec couche isolante intermédiaire et méthode de fabrication

(30) Priorität: 05.10.2005 DE 102005047567
(43) Veröffentlichungstag der Anmeldung: 11.04.2007
(73) Patentinhaber: Semikron Elektronik GmbH & Co. KG Patentabteilung, 90431 Nürnberg (DE)
(72) Erfinder: Heilbronner, Heinrich, Dr., 90547 Stein (DE); Kobolla, Harald, Dr., 90556 Seukendorf (DE)

(56) Entgegenhaltungen:
- EP-A- 1 538 667
- WO-A2-20/05027222
- DE-C1- 19 617 055

## Beschreibung

Die Erfindung beschreibt ein Leistungshalbleitermodul bestehend aus einem Gehäuse mit mindestens einem darin angeordneten elektrisch isolierenden Substrat vorzugsweise zur direkten Montage auf einem Kühlkörper. Das Substrat besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weist das Leistungshalbleitermodul Anschlusselemente für externe Last- und Hilfsanschlüsse und auch Verbindungselemente für Verbindungen im Inneren des Leistungshalbleitermoduls auf. Weiterhin wird ein Verfahren zur Herstellung eines oben genannten Leistungshalbleitermoduls beschrieben.

Leistungshalbleitermodule, die Ausgangspunkt dieser Erfindung sind, sind beispielhaft bekannt aus der DE 196 17 055 C1. Diese Druckschrift offenbart ein Leistungshalbleitermodul der oben genannten Art, wobei die Leistungshalbleiterbauelemente auf den Verbindungsbahnen des Substrats mittels einer Lötverbindung angeordnet sind.

Gemäß der als Stand der Technik genannten Druckschrift sind diese Substrate derartiger Leistungshalbieitermodule ausgebildet als elektrisch isolierende Substrate bestehend aus einem Isolierstoffkörper als Trägermaterial und zur elektrischen Isolierung zu einer Grundplatte oder zu einem Kühlkörper. Dieser Isolierstoffkörper besteht nach dem Stand der Technik aus einer Industriekeramik beispielhaft Aluminiumoxid oder Aluminiumnitrit. Auf diesem Isolierstoffkörper auf dessen dem Inneren des Leistungshalbleitermoduls zugewandten ersten Hauptfläche befinden sich eine Mehrzahl von gegeneinander elektrisch isolierten metallischen Verbindungsbahnen. Auf diesen wiederum sind die Leistungshalbleiterbauelemente angeordnet.

Meist weist der Isolierstoffkörper auf seiner dem Inneren des Leistungshalbleitermoduls abgewandten zweiten Hauptfläche ebenfalls eine metallische Schicht gleichen Materials und gleicher Dicke wie diejenige der Verbindungsbahnen auf der ersten Hauptfläche auf. In der Regel ist diese Schicht allerdings nicht in sich strukturiert, da sie beispielhaft der Lötverbindung zu einer Grundplatte oder zur thermisch leitenden Verbindung zu einem Kühlkörper dient. Die Verbindungsbahnen sowie die metallische Schicht der zweiten Hauptfläche bestehen vorzugsweise aus nach dem DCB (direct copper bonding) Verfahren aufgebrachten Kupfer, wobei das Kupfer hierbei eine typische Dicke von weniger als 1 mm aufweist.

Häufig beschriebene Verbindungselemente zwischen den Leistungshalbleiterbauelementen und den Verbindungsbahnen sind Bondverbindungen und hier speziell Drahtbondverbindungen. Die oben genannte Druckschrift offenbart als alternative Lösung der schaltungsgerechten Verbindungen der Leistungshalbleiterbauelemente miteinander und / oder mit Verbindungsbahnen eine flexible Leiterplatte, die mit den Leistungshalbleiterbauelementen und / oder den Verbindungsbahnen mittels Lötverbindungen stoffbündig erfolgt oder mittels Druckkontakttechnik stoffschlüssig erfolgt. Die offenbarte Leiterplatte weist hierzu einen Mehrschichtaufbau auf, um sowohl Lastanschlussverbindungen, wie auch Steuer- und Hilfsanschlussverbindungen bereitzustellen. Innerhalb eines Schichtaufbaus dieser flexiblen Leiterplatte können einzelne Schichten strukturiert und / oder mit anderen Schichten oder Schichtabschnitten mittels Durchkontaktierungen verbunden sein.

Zur Inneren Isolation sind vielfältig Leistungshalbleitermodule bekannt, die im Bereich der Leistungshalbleiterbauelemente und bis oberhalb der Verbindungselemente, die hierbei häufig als Bondverbindungen ausgestaltet sind, mit einer Vergussmasse mit hoher Dielektrizitätskonstante vergossen sind. Die oben genannte Druckschrift DE 196 17 055 C1 ersetzt derartige Vergussmassen durch Isolationszwischenlagen, wie sie grundsätzlich aus der Herstellung von Leiterplatten bekannt sind. Diese Isolationszwischenlagen umfassen die Leistungshalbleiterbauelemente und weisen an ihrem Rand einen Kantenbelag auf, der Spannungsüberschläge in diesem Randbereich verhindern soll. Weiterhin sind die Isolationszwischenlagen derart ausgebildet, dass sie die gleiche Dicke wie die von ihnen umfassten Leistungshalbleiterbauelemente aufweisen um somit eine ebene Fläche für die Anordnung der flexiblen Leiterbahn auszubilden.

Nachteilig an der Ausgestaltung eines Leistungshalbleitermoduls nach oben genannter Druckschrift ist, dass die Isolationszwischenlagen ausschließlich der inneren Isolation des Leistungshalbleitermoduls dienen und somit die Herstellung eines derartig ausgebildeten Leistungshalbleitermoduls im Vergleich zu einem mit Vergussmasse bei gleichem Nutzen aufwendiger ist, da die Isolationszwischenlagen angepasst und in einem zusätzlichen Schritt von einem Vorprodukt zu einer festen Isolationslage weiterbehandelt werden müssen. Weiterhin nachteilig ist, dass die Kanten der Isolationszwischenlage zusätzlich beschichtet werden müssen, um Spannungsüberschläge sicher zu verhindern.

Beispielhaft aus der DE 34 14 065 C2 und der nicht vorveröffentlichten DE 10 2004 019 567 A1 sind Drucksinterverfahren bekannt, welche eine dauerhafte Verbindung zwischen einem Leistungshalbleiterbauelement und einem Anschlusselement oder einem Substrat offenbaren. Die offenbarten Verfahren eignen sich allerdings nur für die gleichzeitige Sinterverbindung eines einzelnen Leistungshalbleiterbauelements mit einem Anschlusselement oder einem Substrat. Dies liegt darin begründet, dass hierbei die Druckeinleitung ausschließlich auf die plane Fläche des Leistungshalbleiterbauelements erfolgen kann. Bei einer Druckeinleitung auf den Randbereich des Leistungshalbleiterbauelements führen die bekannten Werte des Drucks in einer Größenordnung von 10 MPa bis 60 MPa zu einer mechanischen Zerstörung dieses Randbereichs bzw. des Leistungshalbleiterbauelements.

Die WO 2005/027222 A2 offenbart eine Anordnung eines elektrischen Bauelements auf einem Substrat, wobei eine elektrische Isolationsfolie zur elektrischen Isolierung der Bauelement auf der Anordnung aus Bauelement und Substrat derart angeordnet ist, dass deren gegebene Oberflächestruktur in einer Oberflächenkontur der Isolationsfolie abgebildet ist. Hierzu wird eine Folie die vorzugsweise eine deutlich geringere Dicke im Vergleich zu einem Bauelement aufweist auf diese Oberflächenstruktur auflaminiert.

Der Erfindung liegt die Aufgabe zugrunde ein Leistungshalbleitermodul und ein zugehöriges Herstellungsverfahren vorzustellen wobei ein Mittel zur inneren Isolation eine Mehrzahl von Funktionen, wie beispielhaft eine Verbesserung dieser inneren Isolation, aufweist und einer rationellen Fertigung zugänglich ist.

Die Aufgabe wird erfindungsgemäß gelöst, durch die Maßnahmen der Merkmale der Ansprüche 1 und 2. Bevorzugte Ausführungsformen sind in den Unteransprüchen beschrieben.

Der erfinderische Gedanke geht aus von einem Leistungshalbleitermodul vorzugsweise zur direkten Montage auf einem Kühlkörper oder mit einer Grundplatte. Dieses Leistungshalbleitermodul weist mindestens folgende Komponenten auf: ein Gehäuse, Anschlusselemente für Last- und Hilfsanschlüsse, mindestens ein Substrat mit Verbindungsbahnen und mindestens ein Leistungshalbleiterbauelement.

Die Anschlusselemente für die Lastanschlüsse führen aus dem Gehäuse heraus und dienen der elektrischen Verbindung der im Gehäuseinneren angeordneten Leistungshalbleiterbauelemente. Das zur Grundplatte oder einem Kühlkörper elektrisch isolierend ausgebildeten Substrat besteht seinerseits aus einem Isolierstoffkörper, vorzugsweise einer Industriekeramik, und hierauf, auf dessen der Grundplatte oder dem Kühlkörper abgewandten ersten Hauptfläche befindlich, einer Mehrzahl von gegeneinander elektrisch isolierten metallischen Verbindungsbahnen. Auf diesen Verbindungsbahnen sind Leistungshalbleiterbauelemente angeordnet und schaltungsgerecht mittels Verbindungselementen verbunden. Diese Verbindungselemente sind hier beispielhaft ausgebildet als eine flexible Leiterplatte nach dem oben genannten Stand der Technik oder als bekannte Verschienung mittels in Stanz- Biegetechnik hergestellter metallsicher Verbindungsschienen.

Das Leistungshalbleitermodul weist weiterhin mindestens einen Isolationsformkörper auf, der mindestens ein Leistungshalbleiterbauelement umschließt und nach einem im Folgenden beschriebenen Verfahren derart verformt ausgebildet ist, dass er allseits an den Rändern des zugeordneten Leistungshalbleiterbauelements anliegt und umschließt. Das zugeordnete Verbindungselement ist hierbei beispielhaft als flexible Leiterplatte ausgestaltet und verbindet das von dem Isolationsformkörper umschlossen Leistungshalbleiterbauelement beispielhaft mit einem Anschlusselement oder einem weiteren Leistungshalbleiterbauelement. Die elektrisch leitende Verbindung des Leistungshalbleiterbauelements zur zugeordneten Leiterbahn des Substrats und / oder zum Verbindungselement, hier der flexiblen Leiterplatte, ist als Drucksinterverbindung ausgebildet.

Das erfindungsgemäße Verfahren zur Herstellung eines Leistungshalbleiterbauelements weist außer bekannten Herstellungsschritten für Leistungshalbleitermodule noch die folgenden auf:
- Anordnen mindestens eines, mindestens einmalig verformbaren, Isolationsformkörpers, wobei dieser mindestens ein Leistungshalbleiterbauelement auf dem Substrat umfasst und hierbei nicht an den Rändern des Leistungshalbleiterbauelements anliegt. Dieser Isolationsformkörper weist eine größere Höhe auf als das umfasste Leistungshalbleiterbauelement. Weiterhin ist sind der Isolationsformkörper und das Leistungshalbleiterbauelement derart zueinander angeordnet, dass zwischen dem Isolationsformkörper und dem Leistungshalbleiterbauelement dieses umfassend ein Spalt mit im Wesentlichen gleicher Breite auf allen Seiten ausgebildet ist.
- Vorzugsweise zusätzliche Anordnung mindestens eines Verbindungselements zur schaltungsgerechten Verbindung des Leistungshalbleiterbauelements oberhalb dieses Leistungshalbleiterbauelements und des dieses umfassenden Isolationsformkörpers.
- Druckbeaufschlagung im Rahmen eines Drucksinterprozesses auf das Verbindungselement oder direkt auf das mindestens eine Leistungshalbleiterbauelement und den umfassenden Isolationsformkörper. Hierbei wird eine Drucksinterverbindung des Leistungshalbleiterbauelement mit einer Leiterbahn des Substrats und / oder mit dem Verbindungselementen ausgebildet. Bei beiden Ausgestaltungen dieser Druckbeaufschlagung vorzugsweise mit zusätzlicher Temperaturbeaufschlagung verformt sich der Isolationsformkörper derart, dass er allseits an den Rändern des Leistungshalbleiterbauelements anliegt und somit das Leistungshalbleiterbauelement umschließt. Dieses Anliegen des Isolationsformkörpers verhindert eine Zerstörung des Leistungshalbleiterbauelements während des Drucksinterprozesses.

Die erfinderische Lösung wird an Hand der Fig. 1 bis 4 weiter erläutert.

Fig. 1 zeigt ein erfindungsgemäßes Leistungshalbleitermodul im Querschnitt.

Fig. 2 zeigt Herstellungsschritte des erfindungsgemäßen Verfahrens.

Fig. 3 zeigt in dreidimensionaler Darstellung eine Anordnung eines Isolationsformkörpers und eines Substrats.

Fig. 4 zeigt eine Draufsicht des Isolationsformkörpers und des Substrats nach Fig. 3.

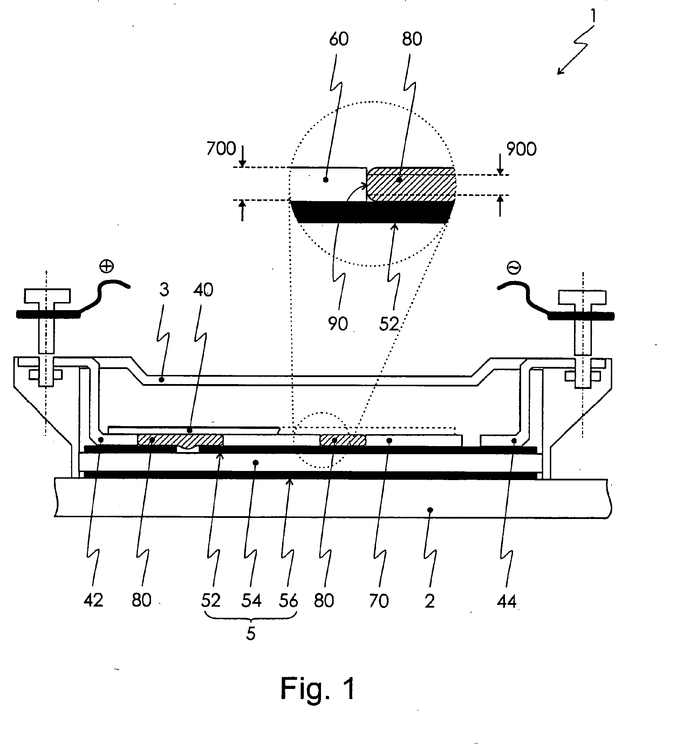

Fig. 1 zeigt ein erfindungsgemäßes Leistungshalbleitermodul (1) zur direkten Montage auf einem Kühlkörper (2). Das Leistungshalbleitermodul (1) weist ein Gehäuse (3) sowie ein hierin angeordnetes Substrat (5)auf, das aus einem Isolierstoffkörper (54) sowie aus metallischen Kaschierungen, die auf beiden Hauptflächen des Isolierstoffkörpers (54) angeordnet sind, besteht. Die dem Kühlkörper (2) zugewandte metallische Kaschierung (56) der zweiten Hauptfläche des Isolierstoffkörpers (54) dient der thermischen Ankopplung, ist flächig ausgebildet und in sich nicht strukturiert. Demgegenüber ist die dem Leistungshalbleitermodulinneren zugewandte Kaschierung der ersten Hauptfläche des Isolierstoffkörpers (54) in sich strukturiert und bildet somit die Verbindungsbahnen (52) des Substrats (5) aus.

Die Anschlusselemente (42, 44) der Leistungsanschlüsse werden gebildet durch Metallformkörper, die an ihrem einen Ende beispielhaft löttechnisch mit der zugeordneten Verbindungsbahn (52) verbunden sind und an ihrem anderen Ende eine Ausnehmung zur Schraubverbindung aufweisen.

Auf den Verbindungsbahnen (52) sind die Leistungshalbleiterbauelemente (70), hier dargestellt Leistungsdioden, angeordnet. Die schaltungsgerechte Verbindung der Leistungsdioden (70) miteinander und mit einem Anschlusselement (40) ist als flexible Leiterplatte (40) ausgebildet. Die elektrisch leitende Verbindung zwischen den Leistungsdioden (70) und der flexiblen Leiterplatte (40) ist als Drucksinterverbindung, diejenige zwischen den Leistungshalbleiterbauelement (70) und den Verbindungsbahnen (52) als Lötverbindung ausgebildet.

Zur inneren elektrischen Isolation weist das Leistungshalbleitermodul einen Isolationsformkörper (80) auf. Dieser umschließt die Leistungsdioden (70) allseits, wobei die Kontaktfläche (90) zwischen dem Isolationsformkörper (80) und dem Rand des Leistungshalbleiterbauelements (70) eine größere Höhe (900) aufweist als die halbe Dicke (700) des Leistungshalbleiterbauelements (70). Dies ist entscheidend um Randüberschläge am Leistungshalbleiterbauelement (70) zu verhindern. Weiterhin reicht dieser Isolationsformkörper (80) bis zum Anschlusselement (42) positiver Polarität und ist mit mindestens einer Fläche dieses Anschlusselements (42) elektrisch leitend verbunden. Da der Isolationsformkörper (80) hierbei zwei Leiterbahnen (52) überdeckt und aufgrund des beschriebenen Herstellungsverfahren des Leistungshalbleitermoduls (1) mittels Drucksintertechnik reicht ein Teil des Isolationsformkörpers (80) in den Spalt zwischen den beiden Leiterbahnen (52) hinein.

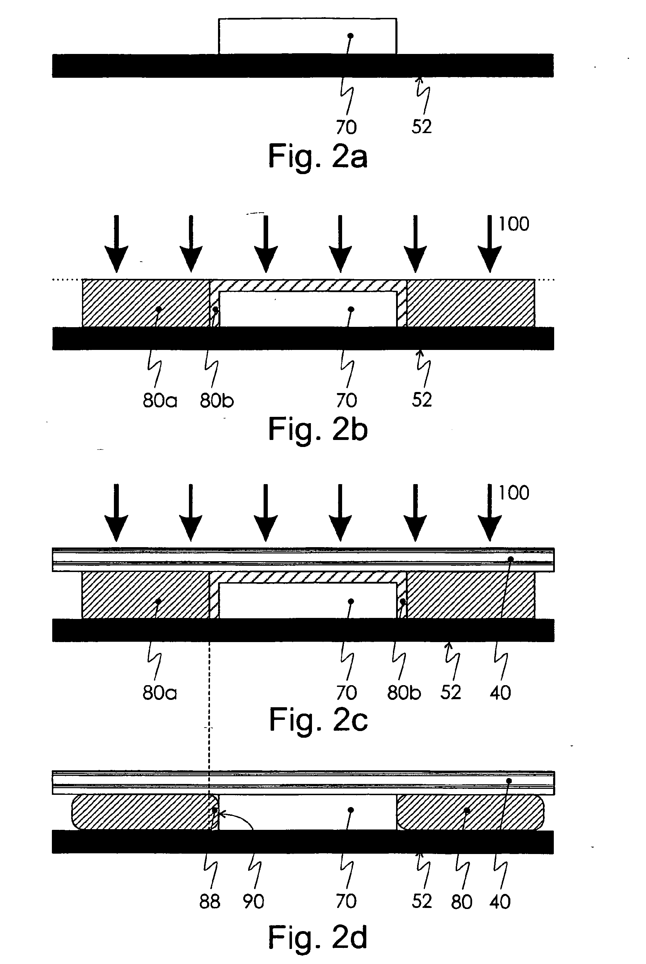

Fig. 2 zeigt Herstellungsschritte des erfindungsgemäßen Verfahrens. Eine erste Ausführungsvariante des erfindungsgemäßen Verfahrens geht aus von einem Substrat mit einer darauf angeordneten Leiterbahn (52). Auf dieser Leiterbahn (52) wird mindestens ein Leistungshalbleiterbauelement (70) mit einer geeignet ausgebildeten Zwischenschicht zur Drucksinterverbindung anordnet (Fig. 2a). Diese Leistungshalbleiterbauelement allseits umfassend wird ein lsolationsformkörper (80 a/b) angeordnet (Fig. 2b). Dieser weist vorzugsweise ein Dicke auf, die zwischen 2 von 100 und 10 von 100 größer ist als die Dicke des Leistungshalbleiterbauelements (70). Der Abstand zwischen den Ränder des Leistungshalbleiterbauelement (70) und dem umfassenden Isolationsformkörper (80) beträgt vorzugsweise zwischen 10 von 100 und 30 von 100 der Dicke des Leistungshalbleiterbauelements (70). Dieser Isolationsformkörper (80) ist vorzugsweise aus einem mindestens einmalig unter Druck und gegebenenfalls zusätzlicher Temperaturbeaufschlagung verformbaren Kunststoff ausgebildet. Eine nicht reversible Verformung ist hierbei besonders vorteilhaft.

Im Anschluss erfolgt die plane Druckbeaufschlagung (100) auf das Leistungshalbleiterbauelement (70) und den Isolierstoffkörper (80), der sich hierbei verformt. Diese Verformung, die vorzugsweise mit einer vorangehenden und / oder gleichzeitigen Temperaturbeaufschlagung mit einer Temperatur zwischen 50°C und 300°C verbunden ist, verringert die Dicke des Isolationsformkörpers (80) auf die Dicke des Leistungshalbleiterbauelements (70), wobei sich der Isolationsformkörper (80) gleichzeitig seitlich ausdehnt (86). Hierdurch wird der Spalt zwischen dem Leistungshalbleiterbauelement (70) und Isolationsformkörper (80) geschlossen wodurch dieser Isolationsformkörper (80) somit das Leistungshalbleiterbauelement (70) umschließt bevor die Druckeinleitung auf das Leistungshalbleiterbauelement (70) erfolgt. Die Kontaktflächen (90) weisen hierbei vorzugsweise eine Höhe auf, die größer ist als die halbe Dicke des Leistungshalbleiterbauelements (70). Durch den geeignet gewählten Werkstoff des Isolationsformkörpers (80) verbleibt dieser Verbund bestehen und dient in einem Leistungshalbleitermodul (1) der inneren Isolation und verhindert durch seine Ausgestaltung im Betrieb Randüberschläge des Leistungshalbleiterbauelements (70).

Nach Beendigung des Drucksinterprozesses und im Einsatz im Leistungshalbleitermodul weist der Isolationsformkörper die gleiche (Fig. 2d) oder eine geringfügig größere Dicke als das umschlossene Leistungshalbleiterbauelement auf.

In einer zweiten Ausführungsvariante des erfindungsgemäßen Verfahrens wird vor dem Drucksinterprozess noch eine flexible Leiterplatte (40) oder mindestens eine Verbindungsschiene als Verbindungselement oberhalb des Leistungshalbleiterbauelements (70) und auf dem Isolierstoffkörper (80) angeordnet (Fig. 2c). Die Bereiche, die später die Kontaktflächen zwischen dem Leistungshalbleiterbauelement (70) und dem Verbindungselement (40) ausbilden sind für ein Drucksinterverfahren entsprechend vorbereitet. Es ist hierzu im Bereich der Kontaktflächen eine geeignet Edelmetalloberfläche auf dem Leistungshalbleiterbauelement (70) und auf dem Verbindungselement (40) ausgebildet. Ebenso ist ein Sintermetall geeignet angeordnet. Bei einer plan eingeleiteten Druck- und vorzugsweise gleichzeitiger Temperaturbeaufschlagung auf das Verbindungselement (40) wird eine Drucksinterverbindung zwischen dieser und dem Leistungshalbleiterbauelement (70) und gleichzeitig zwischen dem Leistungshalbleiterbauelement (70) und der Leiterbahn (52) des Substrats (5) ausgebildet.

Eine dritte Ausführungsvariante des erfindungsgemäßen Verfahrens geht aus von einem auf die zugeordnete Leiterbahn (52) eines Substrats (5) gelöteten Leistungshalbleiterbauelement (70) (Fig. 2a), welches von einem Isolationsformköper (80) umfasst wird und wobei eine flexible Leiterbahn (40) auf diesem angeordnet ist. Durch den Drucksinterprozess wird somit eine Sinterverbindung zwischen dem Leistungshalbleiterbauelement (70) und der Verbindungselement (40) geschaffen.

Vorteilhaft an allen oben beschriebenen Ausführungsformen des Verfahrens ist, dass in einem einzigen Drucksinterprozess, durch die Anordnung des Isolationsformkörpers (80), gleichzeitig eine Mehrzahl von Leistungshalbleiterbauelementen (70) mit Leiterbahnen (52) und / oder mit Verbindungselementen (40) verbunden werden können.

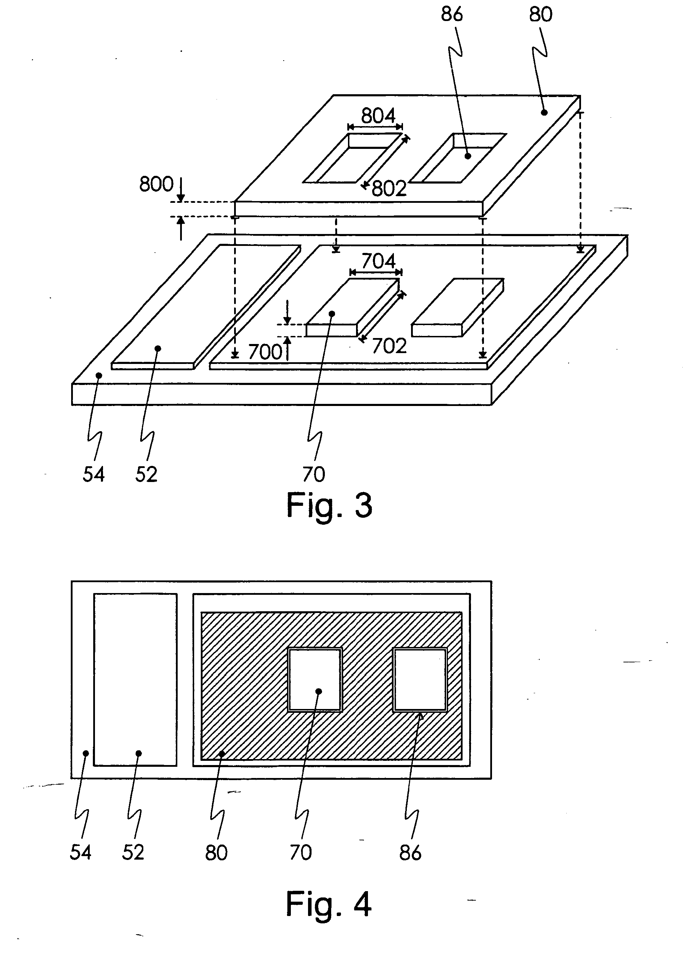

Fig. 3 zeigt in dreidimensionaler Darstellung die Anordnung des Isolationsformkörpers (80) und des Substrats (5). Ausgangspunkt der Herstellung des unter Fig. 1 beschriebenen Leistungshalbleitermoduls (1) gemäß dem unter Fig. 2 beschriebenen Herstellungsverfahrens ist ein Substrat nach dem Stand der Technik. Dieses weist einen Isolierstoffkörper (54), hier einer Aluminiumoxidkeramik, und hierauf ausgebildeten Kupferleiterbahnen (52) auf. Diese Kupferleiterbahnen (52) weisen zumindest in denjenigen Bereichen, die als Kontaktflächen für eine Drucksinterverbindung dienen eine weitere Schicht eines Edelmetalls, vorzugsweise Gold, auf. Auf diese Kontaktflächen wird das Sintermetall, vorzugsweise mittels eines Siebdruckverfahrens, aufgebracht. Anschließend werden die Leistungshalbleiterbauelemente (70) angeordnet. Die Leistungshalbleiterbauelemente (70) umfassend wird dann der Isolationsformkörper (80) angeordnet. Dessen Dicke ist hierbei um 2 von 100 bis 10 von 100 größer als diejenige des Leistungshalbleiterbauelements (70). Die Länge (802) der Aussparung (86) des Isolationsformkörpers (80) ist hierbei zwischen 20 von 100 und 60 von 100 der Dicke des Leistungshalbleiterbauelements (70) größer als die Länge (702) des Leistungshalbleiterbauelements (70). Gleiches gilt für die Breite (804) der Aussparung (86) und die Breite (704) des Leistungshalbleiterbauelements (70).

Fig. 4 zeigt eine Draufsicht auf den Isolationsformkörper (80) und das Substrats (5) gemäß Fig. 3. Hierbei ist nochmals deutlich das Umfassen des Leistungshalbleiterbauelements (70) durch den Isolationsformköper (80), ohne dass diese sich vor dem Drucksinterprozess berühren, ersichtlich.

## Patentansprüche

1. Leistungshalbleitermodul (1) mit einem Gehäuse (3), nach außen führenden Anschlusselementen (42, 44), mindestens einem innerhalb des Gehäuses (3) angeordneten elektrisch isolierenden Substrat (5), wobei diese mindestens besteht aus einem Isolierstoffkörper (54) und auf der dem Inneren des Leistungshalbleitermoduls zugewandten ersten Hauptfläche befindlich einer Mehrzahl von gegeneinander elektrisch isolierten metallischen Verbindungsbahnen (52) und mit mindestens einem auf einer dieser Verbindungsbahnen angeordneten Leistungshalbleiterbauelement (70) mit mindestens einem Verbindungselement (40) und mindestens einem strukturierten, mindestens einmalig verformbaren Isolationsformkörper (80), der in nicht verformtem Zustand eine größer Dicke aufweist als das zum umschließende Leistungshalbleiterbauelement (70) und wobei zwischen dem Isolationsformkörper (80) und dem Leistungshalbleiterbauelement (70) dieses umgebend ein Spalt ausgebildet ist,
wobei mindestens eine Verbindung zwischen einem Leistungshalbleiterbauelement (70) und einem Verbindungselement (40) oder zwischen dem Leistungshalbleiterbauelement (70) und der Verbindungsbahn (52) als Drucksinterverbindung ausgebildet ist und
wobei der Isolationsformkörper (80) derart angeordnet ist, dass er aus seiner ursprünglichen Form durch Druck verformt ist, allseits an den Rändern mindestens eines zugeordneten Leistungshalbleiterbauelements (70) anliegt und diese somit umschließt.

2. Verfahren zu Herstellung eines Leistungshalbleitermodul (1) gemäß Anspruch 1 welches mindestens die Schritte aufweist:
• Anordnen mindestens eines Leistungshalbleiterbauelement (70) auf einer Leiterbahn (52) des Substrats (5);
• Anordnen des mindestens einen Isolationsformkörpers (80) jeweils mindestens ein Leistungshalbleiterbauelement (70) umfassend, wobei dieser Isolationsformkörper (80) eine größere Höhe (800) aufweist als die Höhe (700) des zugeordneten Leistungshalbleiterbauelement (70), und wobei zwischen dem Isolationsformkörper (80) und dem Leistungshalbleiterbauelement (70) dieses umgebend ein Spalt ausgebildet ist;
• Druckbeaufschlagung (100) im Rahmen eines Drucksinterprozesses auf das mindestens eine Leistungshalbleiterbauelement (70) und den umgebenden Isolationsformkörper (80) zur Drucksinterverbindung des Leistungshalbleiterbauelement (70), wobei sich der Isolationsformkörper (80) unter der Druckbeaufschlagung (100) derart verformt, dass er allseits an den Rändern des Leistungshalbleiterbauelements (70) anliegt und dieses umschließt.

3. Leistungshalbleitermodul (1) nach Anspruch 1,
wobei die Kontaktfläche (90) zwischen dem Isolationsformkörper (80) und dem Rand des Leistungshalbleiterbauelements (70) eine größere Höhe aufweist als die halbe Dicke (700) des Leistungshalbleiterbauelements (70).

4. Leistungshalbleitermodul (1) nach Anspruch 1,
wobei das Verbindungselement (40) als eine flexible Leiterplatte oder Verbindungsschiene jeweils mit flächigen Kontaktstellen zum Leistungshalbleiterbauelement (70) ausgestaltet ist.

5. Verfahren zur Herstellung eines Leistungshalbleitermodul (1) nach Anspruch 2,
wobei nach der Anordnung des Leistungshalbleiterbauelements (70) und des umfassenden Isolationsformkörpers (80) auf dem Substrat (5) mindestens
• ein Verbindungselement (40) auf dem Isolationsformkörper (80) und dem Leistungshalbleiterbauelement (70) angeordnet wird und
• durch plane Druckbeaufschlagung (100) im Rahmen eines Drucksinterprozesses auf das Verbindungselement (80) der das Leistungshalbleiterbauelement (70) umfassende Isolationsformkörper (80) derart verformt wird, dass er allseits an den Rändern des Leistungshalbleiterbauelements (70) anliegt und bei weiterergehender Druckbeaufschlagung (100) eine Drucksinterverbindung des Leistungshalbleiterbauelements (70) zu der zugeordneten Leiterbahn (52) des Substrats (5) und / oder zu dem Verbindungselement (40) hergestellt wird.

6. Verfahren zur Herstellung eines Leistungshalbleitermoduls (1) nach Anspruch 2 oder 5,
wobei zusätzlich zur Druckbeaufschlagung (100) während und / oder vor dem Drucksinterprozess der Isolationsformkörper noch mit einer Temperatur zwischen 50°C und 300°C beaufschlagt wird.

7. Verfahren zur Herstellung eines Leistungshalbleitermoduls (1) nach Anspruch 2,
wobei eine Mehrzahl von Leistungshalbleiterbauelementen (70) gleichzeitig mittels eines Drucksinterprozesses mit zugeordneten Leiterbahnen (52) und / oder einem oder mehreren Verbindungselementen (40) verbunden werden.

## Claims

1. Power semiconductor module (1) having a housing (3), terminal elements (42, 44) leading to the outside, at least one electrically insulating substrate (5) arranged within the housing (3), said substrate consisting of at least one insulator body (54) and of a plurality of metallic connecting tracks (52) insulated from one another and located on the first main surface facing the interior of the power semiconductor module, and having at least one power semiconductor element (70) arranged on one of said connecting tracks, with at least one connection element (40) and at least one structured shaped insulating body (80), deformable at least once, which in the non-deformed condition has a greater thickness than the power semiconductor element (70) to be enclosed, and
wherein between the shaped insulating body (80) and the power semiconductor element (70) a gap enclosing said element is constructed,
wherein at least one connection between a power semiconductor element (70) and a connection element (40) or between the power semiconductor element (70) and the connecting track (52) is constructed as a pressure sintering connection, and
wherein the shaped insulating body (80) is arranged in such a manner that it is deformed out of its original shape due to pressure, is in contact with the edges on all sides of at least one associated power semiconductor element (70), and thus encloses said elements.

2. Method for producing a power semiconductor module (1) according to Claim 1 which has at least the steps:
• arrangement of at least one power semiconductor element (70) on a conductor track (52) of the substrate (5);
• arrangement of the at least one shaped insulating body (80) so as to enclose in each case at least one power semiconductor element (70), wherein this shaped insulating body (80) is of greater height (800) than the height (700) of the associated power semiconductor element (70), and wherein between the shaped insulating body (80) and the power semiconductor element (70) a gap is constructed that surrounds said element;
• application of pressure (100) as part of a pressure sintering process to the at least one power semiconductor element (70) and the surrounding shaped insulating body (80) for making a pressure sintering connection to the power semiconductor element (70), wherein the shaped insulating body (80) is deformed in such a manner under the application of pressure (100) that it is in contact with the edges on all sides of the power semiconductor element (70) and encloses said element.

3. Power semiconductor module (1) according to Claim 1,
wherein the contact surface (90) between the shaped insulating body (80) and the edge of the power semiconductor element (70) has a height greater than half the thickness (700) of the power semiconductor element (70).

4. Power semiconductor module (1) according to Claim 1,
wherein the connection element (40) is constructed as a flexible circuit board or connection bus-bar with planar points of contact with the power semiconductor element (70).

5. Method for producing a power semiconductor module (1) according to Claim 2, wherein according to the arrangement of the power semiconductor element (70) and of the enclosing shaped insulating body (80) on the substrate (5) at least
• one connection element (40) is arranged on the shaped insulating body (80) and the power semiconductor element (70), and
• by planar application of pressure (100) as part of a pressure sintering process on the connection element (80), the shaped insulating body (80) enclosing the power semiconductor element (70) is deformed in such a manner that it is in contact with the edges on all sides of the power semiconductor element (70) and when further pressure (100) is applied, a pressure sintering connection is created from the power semiconductor element (70) to the associated conductor track (52) of the substrate (5) and / or to the connection element (40).

6. Method for producing a power semiconductor module (1). according to Claim 2 or 5,
wherein in addition to the application of pressure (100) during and / or before the pressure sintering process, the shaped insulating body is also subjected to a temperature between 50°C and 300°C.

7. Method for producing a power semiconductor module (1) according to Claim 2, wherein a plurality of power semiconductor elements (70) are at the same time connected to associated conductor tracks (52) and / or to one or more connection elements (40) by means of a pressure sintering process.

## Revendications

1. Module semi-conducteur de puissance (1) comportant un boîtier (3), des éléments de raccordement (42, 44) conduisant vers l'extérieur, au moins un substrat électriquement isolant (5) agencé à l'intérieur du boîtier (3), ce substrat étant constitué d'un corps isolant (54) et, sur la première surface principale proche de l'intérieur du module semi-conducteur de puissance, de plusieurs pistes de liaison métalliques (52) isolées électriquement les unes des autres, et au moins un composant semi-conducteur de puissance (70) agencé sur l'une de ces pistes de liaison avec au moins un élément de liaison (40) et avec au moins un corps isolant mis en forme (80) structuré, déformable au moins une fois et ayant à l'état non déformé une plus grande épaisseur que le composant semi-conducteur de puissance (70) à envelopper, une fente étant conçue entre le corps isolant mis en forme (80) et le composant semi-conducteur de puissance (70) de manière à envelopper celui-ci,
dans lequel au moins une liaison entre un composant semi-conducteur de puissance (70) et un élément de liaison (40) ou entre le composant semi-conducteur de puissance (70) et la piste de liaison (52) est conçue comme une liaison frittée sous pression, et
dans lequel le corps isolant mis en forme (80) est agencé de telle sorte qu'il est déformé par pression à partir de sa forme initiale, qu'il est adjacent de tous côtés aux bords d'au moins un composant semi-conducteur de puissance (70) associé et qu'il enveloppe donc celui-ci.

2. Procédé de fabrication d'un module semi-conducteur de puissance (1) selon la revendication 1, qui comporte au moins les étapes suivantes :
• agencement d'au moins un composant semi-conducteur de puissance (70) sur une piste conductrice (52) du substrat (5) ;
• agencement de l'au moins un corps isolant mis en forme (80), enveloppant à chaque fois au moins un composant semi-conducteur de puissance (70), ce corps isolant mis en forme (80) ayant une hauteur (800) plus grande que la hauteur (700) du composant semi-conducteur de puissance (70) associé, et une fente étant conçue entre le corps isolant mis en forme (80) et le composant semi-conducteur de puissance (70) de manière à envelopper celui-ci ;
• application d'une pression (100) dans le cadre d'un processus de frittage sous pression sur l'au moins un composant semi-conducteur de puissance (70) et sur le corps isolant mis en forme (80) enveloppant pour la liaison frittée sous pression du composant semi-conducteur de puissance (70), le corps isolant mis en forme (80) se déformant sous l'application de la pression (100) de telle sorte qu'il est adjacent de tous côtés aux bords du composant semi-conducteur de puissance (70) et qu'il enveloppe donc celui-ci.

3. Module semi-conducteur de puissance (1) selon la revendication 1,
dans lequel la surface de contact (90) entre le corps isolant mis en forme (80) et le bord du composant semi-conducteur de puissance (70) a une hauteur plus grande que la moitié de l'épaisseur (700) du composant semi-conducteur de puissance (70).

4. Module semi-conducteur de puissance (1) selon la revendication 1,
dans lequel l'élément de liaison (40) est conçu comme une plaque conductrice souple ou un rail de liaison souple à chaque fois avec des points de contact formant surfaces pour le composant semi-conducteur de puissance (70).

5. Procédé de fabrication d'un module semi-conducteur de puissance (1) selon la revendication 2, dans lequel, après l'agencement du composant semi-conducteur de puissance (70) et du corps isolant mis en forme (80) enveloppant sur le substrat (5),
• au moins un élément de liaison (40) est agencé sur le corps isolant mis en forme (80) et sur le composant semi-conducteur de puissance (70), et
• par une application de pression planaire (100) dans le cadre d'un processus de frittage sous pression sur l'élément de liaison (80), le corps isolant mis en forme (80) comprenant le composant semi-conducteur de puissance (70) est déformé de telle sorte qu'il est adjacent de tous côtés aux bords du composant semi-conducteur de puissance (70) et que, par la poursuite de l'application de pression (100), une liaison frittée sous pression est fabriquée du composant semi-conducteur de puissance (70) à la piste conductrice (52) associée du substrat (5) et/ou à l'élément de liaison (40).

6. Procédé de fabrication d'un module semi-conducteur de puissance (1) selon la revendication 2 ou 5,
dans lequel, en plus de l'application de pression (100), pendant et/ou avant le processus de frittage sous pression, le corps isolant mis en forme est aussi soumis à une température comprise entre 50°C et 300°C.

7. Procédé de fabrication d'un module semi-conducteur de puissance (1) selon la revendication 2,
dans lequel plusieurs composants semi-conducteurs de puissance (70) sont reliés simultanément au moyen d'un processus de frittage sous pression à des pistes conductrices (52) associées et/ou à un ou plusieurs éléments de liaison (40).
